# FASCICULE DE BREVET EUROPEEN

(11) **EP 3 961 934 B1**
(45) Date de publication et mention de la délivrance du brevet: **27.09.2023**
(21) Numéro de dépôt: 21193882.4
(22) Date de dépôt: 30.08.2021
(51) Int. Cl.: H04B 5/00, H02J 50/00, H02J 7/02

(54) **SIGNAL MODULÉ EN FRÉQUENCE**
FREQUENZMODULIERTES SIGNAL
FREQUENCY-MODULATED SIGNAL

(30) Priorité: 31.08.2020 FR 2008835
(43) Date de publication de la demande: 02.03.2022
(73) Titulaire: STMicroelectronics (Grand Ouest) SAS, 72100 Le Mans (FR)
(72) Inventeur: CIMAZ, Lionel, 35137 PLEUMELEUC (FR)
(74) Mandataire: Cabinet Beaumont

(56) Documents cités:
- US-A1- 2017 149 291
- "The Qi wireless power transfer system power class 0 specification - Parts 1 and 2: Interface definitions", IEC PAS 63095-1:2017, IEC, 3, RUE DE VAREMBÉ, PO BOX 131, CH-1211 GENEVA 20, SWITZERLAND, 10 mai 2017 (2017-05-10), pages 1-160, XP082011518,

## Description

### Domaine technique

La présente description concerne de façon générale les circuits électroniques, et plus particulièrement les circuits électroniques adaptés à transmettre un signal radiofréquence modulé en fréquence.

### Technique antérieure

On connaît des circuits ou dispositifs électroniques adaptés à transmettre des données ou informations via un signal radiofréquence modulé en fréquence. Ces circuits comprennent chacun une antenne et un circuit de commande configuré pour fournir à l'antenne un signal radiofréquence modulé en fréquence à transmettre à un autre circuit. Parmi ces circuits, on connaît des circuits également adaptés à transmettre une puissance d'alimentation sans fil à un autre dispositif, par l'intermédiaire d'un champ électromagnétique émis par leurs antennes et reçu par une antenne du dispositif à alimenter. Dans de tels circuits, l'émission du signal radiofréquence modulé en fréquence permet de transmettre des informations au dispositif à alimenter, par exemple en vue d'établir la puissance d'alimentation sans fil qui doit être fournie au dispositif à alimenter. US 2017/149291 A1 (IWASAKI TATSUYA [JP] ET AL) 25 mai 2017 décrit un dispositif pour trasmettre un signal radiofréquence modulé en fréquence.

### Résumé de l'invention

Il existe un besoin de pallier au moins certains inconvénients des circuits électroniques connus adaptés à transmettre un signal radiofréquence modulé en fréquence.

Par exemple, il existe un besoin de pallier au moins certains inconvénients des circuits électroniques connus adaptés à transmettre un signal radiofréquence modulé en fréquence et à fournir une alimentation sans fil à un dispositif à alimenter.

Un mode de réalisation pallie tout ou partie des inconvénients des circuits électroniques connus adaptés à transmettre un signal radiofréquence modulé en fréquence.

Un mode de réalisation pallie tout ou partie des inconvénients des circuits électroniques connus adaptés à transmettre un signal radiofréquence modulé en fréquence et à transmettre une alimentation sans fil à un dispositif à alimenter.

L'invention est définie par les revendications indépendantes 1 et 2. Des modes de réalisation sont décrits dans les revendications dépendantes.

Un mode de réalisation prévoit un procédé d'exécution d'un jeu d'instructions successives, dans lequel :
chaque instruction correspond à une commutation d'un signal, un délai, et une condition sélectionnée parmi une première, une deuxième et une troisième conditions ;
chaque exécution d'une instruction comprend :
   - effectuer, à l'expiration dudit délai, ladite commutation dudit signal si la condition est la première condition, si la condition est la deuxième condition et qu'un drapeau est à un état actif, et si la condition est la troisième condition et que le drapeau est à un état inactif, et
   - ne pas effectuer ladite commutation si la condition est la deuxième condition et que le drapeau est à l'état inactif, et si la condition est la troisième condition et que le drapeau est à l'état actif ; et
une première instruction est représentative d'une première commutation d'un premier signal, d'un premier délai et de la deuxième condition et est immédiatement suivie d'une deuxième instruction représentative de ladite première commutation dudit premier signal, d'un deuxième délai et de la troisième condition.

Un mode de réalisation prévoit un dispositif adapté à mettre en oeuvre le procédé ci-dessus comprenant :
- un circuit de mémorisation dans lequel est enregistré le jeu d'instruction ; et
- un circuit de traitement configuré pour exécuter les instructions les unes après les autres.

Selon un mode de réalisation, plusieurs exécutions du jeu d'instructions sont mises en oeuvre les unes à la suite des autres.

Selon un mode de réalisation, chaque exécution complète du jeu d'instructions correspond à un cycle du premier signal, le premier signal étant périodique.

Selon un mode de réalisation, un état courant du drapeau est mis à jour chaque fois qu'un nombre donné de cycles du premier signal est atteint, ledit nombre donné étant de préférence égal à 256.

Selon un mode de réalisation, des états successifs suivants du drapeau sont stockés dans une file d'attente.

Selon un mode de réalisation, le dispositif comprend un compteur configuré pour compter ledit nombre donné de cycles du premier signal et pour indiquer que ce nombre donné de cycles est atteint, le dispositif étant configuré pour mettre à jour le drapeau lorsque le nombre donné de cycles est atteint.

Selon un mode de réalisation, l'état actif du drapeau détermine une fréquence du premier signal et l'état inactif du drapeau détermine une autre fréquence du premier signal.

Selon un mode de réalisation, une différence entre ladite fréquence et ladite autre fréquence est égale à l'inverse d'une différence entre les premier et deuxième délais.

Selon un mode de réalisation, une différence entre les premier et deuxième délais est programmable.

Selon un mode de réalisation, chaque délai est égal à un nombre entier correspondant de cycles d'un signal d'horloge.

Selon un mode de réalisation, une fréquence du signal d'horloge est supérieure ou égale à 50 MHz.

Selon un mode de réalisation, la fréquence du premier signal est comprise entre 110 KHz et 205 KHz.

Selon un mode de réalisation, le premier signal est un signal de commande d'une antenne, par exemple d'un demi pont auquel est connectée l'antenne, l'état actif du drapeau correspond à un premier état binaire d'un bit à transmettre via l'antenne et l'état inactif du drapeau correspond à un deuxième état binaire du bit à transmettre via l'antenne.

Un mode de réalisation prévoit un chargeur sans fil comprenant le dispositif décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme de blocs, un exemple d'un système comprenant un dispositif adapté à transmettre un signal radiofréquence modulé en fréquence, et un autre dispositif adapté à recevoir le signal modulé ;
la figure 2 illustre, sous la forme d'un chronogramme, un exemple de bits transmis via un signal modulé en fréquence ;
la figure 3 représente, de manière très schématique et sous forme de blocs, un exemple d'un circuit adapté à générer un signal modulé en fréquence en fonction d'une valeur d'un bit à transmettre ;
la figure 4 représente, de manière très schématique, et sous forme de blocs, un mode de réalisation d'un dispositif adapté à générer un signal modulé en fréquence en fonction d'une valeur d'un bit à transmettre ;
la figure 5 illustre, sous la forme d'un chronogramme, un exemple d'un mode de mise en oeuvre d'un procédé, par exemple, par le dispositif de la figure 4 ;
la figure 6 illustre, sous la forme de chronogrammes, un autre exemple d'un mode de mise en oeuvre d'un procédé, par exemple, par le dispositif de la figure 4 ; et
la figure 7 représente, de manière schématique, et sous la forme de blocs, une variante de réalisation du dispositif de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

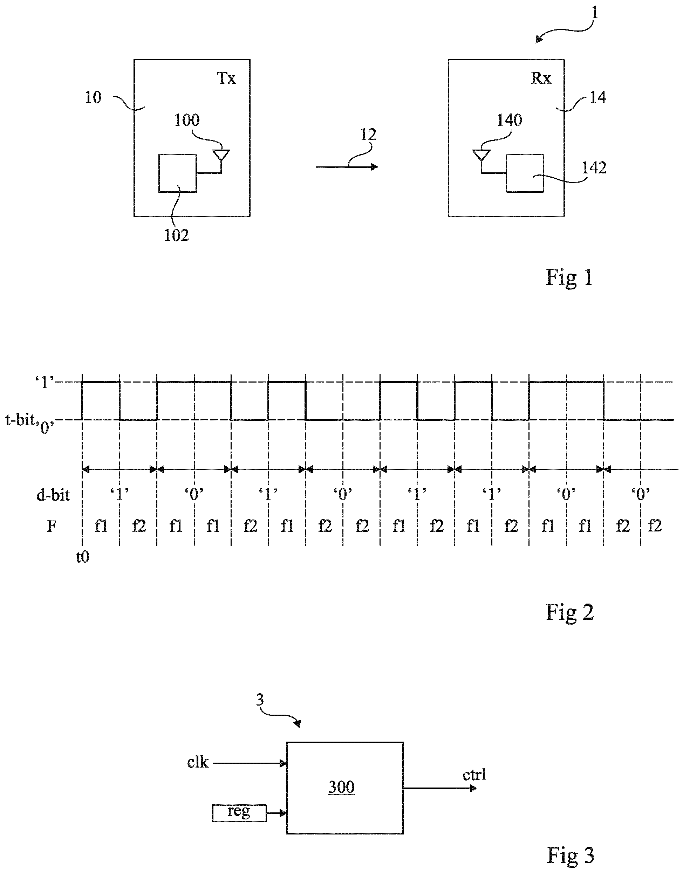

La figure 1, représente, sous la forme de blocs, un exemple d'un système 1 comprenant un dispositif 10 (bloc Tx) adapté à transmettre un signal radiofréquence 12 modulé en fréquence, et un autre dispositif 14 (bloc Rx) adapté à recevoir le signal modulé 12.

Le dispositif 10 comprend une antenne 100 configurée pour émettre le signal radiofréquence 12 modulé en fréquence (représenté ici sous la forme d'une flèche). Le dispositif 10 comprend en outre un circuit de commande 102 configuré pour fournir le signal 12 à l'antenne 100, ou, dit autrement pour commander l'antenne 100 de sorte que le signal 12 soit émis par celle-ci.

De manière similaire, le dispositif 14 comprend une antenne 140 configurée pour recevoir le signal 12. Le dispositif 14 comprend en outre un circuit de commande 142 configuré pour déterminer, à partir du signal 12 reçu par l'antenne 140, des valeurs de bits transmis par le dispositif 10 au dispositif 14.

Dans cet exemple, le dispositif 10 est en outre adapté à transmettre une alimentation sans fil au dispositif 14. Pour cela, le circuit 102 est en outre configuré pour transmettre à l'antenne un signal radiofréquence d'alimentation du dispositif 14, ou, dit autrement, pour commander l'antenne 100 de sorte qu'elle émette un champ magnétique radiofréquence qui, lorsqu'il est reçu par l'antenne 140 du dispositif 14, permet l'alimentation électrique du dispositif 14, par exemple en vue de recharger une batterie (non représentée) du dispositif 14. Le dispositif 10 est alors couramment appelé chargeur sans fil.

Dans cet exemple, le dispositif 14 est en outre configuré pour moduler l'amplitude du signal 12 émis par le dispositif 10, de manière à transmettre des informations, par exemple des bits, au dispositif 10. Pour cela, le circuit 142 est par exemple configuré pour modifier l'impédance de l'antenne 140, de sorte que cette modification d'impédance résulte en une modulation de l'amplitude du signal radiofréquence 12. Le circuit 102 est alors, par exemple, configuré pour déterminer, à partir des modulations d'amplitude du signal 12 au niveau de l'antenne 100, les informations transmises par le dispositif 14 au dispositif 12.

A titre d'exemple, la prévision d'une transmission d'informations du dispositif 10 vers le dispositif 14, et du dispositif 14 vers le dispositif 10, dans le cas où le dispositif 10 est un chargeur sans fil, permet aux dispositifs 10 et 14 de déterminer la puissance d'alimentation sans fil que le dispositif 10 devra fournir au dispositif 14.

A titre d'exemple, la transmission d'informations du dispositif 10 vers le dispositif 14 en modulant la fréquence du signal 12, la transmission d'information du dispositif 14 au dispositif 10 en modulant l'amplitude du signal 12, et la fourniture d'une puissance d'alimentation au dispositif 14 par le dispositif 10 sont mises en oeuvre selon l'une des versions 1.2.x de la spécification Qi développée par le consortium sur la puissance sans fil ("Wireless Power Consortium") ou WPC, par exemple selon la version 1.2.3.

La figure 2 illustre, sous la forme d'un chronogramme, un exemple de bits transmis par un signal modulé en fréquence, par exemple des bits t_bit transmis par le signal 12 (figure 1) modulé en fréquence, du dispositif 10 au dispositif 14.

Dans cet exemple, chaque bit t_bit à la valeur '1' est transmis en émettant un nombre X donné de cycles du signal 12 alors que la fréquence F du signal 12 est égale à une fréquence f1, et chaque bit t_bit à la valeur '0' est transmis en émettant le même nombre X de cycles du signal 12 alors que la fréquence F est égale à une fréquence f2, différente de la fréquence f1. A titre d'exemple, dans les versions 1.2.x de la spécification Qi, le nombre X est, par exemple, égal à 256.

Dans l'exemple de la figure 2, les bits t_bit qui sont transmis à partir d'un instant t0 sont égaux successivement à '1', '0', '1', '1', '0', '1', '0', '0', '1', '0', '1', '0', '1', '1', '0' et '0'. Ainsi, à partir de l'instant t0, la fréquence F du signal 12 est successivement égale à la fréquence f1 pendant 256 cycles ou périodes du signal 12, à la fréquence f2 pendant 256 cycles du signal 12, à la fréquence f1 pendant 512 cycles du signal 12, à la fréquence f2 pendant 256 cycles du signal 12, à la fréquence f1 pendant 256 cycles du signal 12, à la fréquence f2 pendant 512 cycles du signal 12, à la fréquence f1 pendant 256 cycles du signal 12, à la fréquence f2 pendant 256 cycles du signal 12, à la fréquence f1 pendant 256 cycles du signal 12, à la fréquence f2 pendant 256 cycles du signal 12, à la fréquence f1 pendant 512 cycles du signal 12 et à la fréquence f2 pendant 512 cycles du signal 12.

Dans cet exemple, les bits t_bit qui sont transmis par le signal 12 résultent d'un encodage de bits de données d_bit que le dispositif 10 transmet au dispositif 14. Dans cet exemple, l'encodage utilisé est un encodage biphasé différentiel, par exemple un encodage différentiel de Manchester. Plus particulièrement, dans cet exemple :
- un bit d_bit à '1' est encodé par deux bits t_bit successifs ayant des valeurs opposées,
- un bit d_bit à '0' est encodé par deux bits t_bit successifs ayant des valeurs identiques, et
- pour chaque premier et deuxième bits d_bit successifs, le premier bit t_bit encodant le deuxième bit d_bit à une valeur opposée à celle du deuxième bit t_bit encodant le premier bit d_bit.

Ainsi, dans l'exemple de la figure 2, à partir de l'instant t0, le dispositif 10 transmet au dispositif 14 des bits de donnée d_bit égaux successivement à '1', '0', '1', '0', '1', '1', '0' et '0'.

La figure 3 représente, de manière très schématique et sous forme de blocs, un exemple d'un circuit ou dispositif 3 adapté à générer un signal ctrl modulé en fréquence en fonction d'une valeur d'un bit à transmettre t_bit.

Le signal ctrl est un signal de commande de l'antenne 100 (figure 1), dont la fréquence détermine la fréquence F du signal 12. De préférence, la fréquence F du signal 12 est égale à la fréquence du signal ctrl.

A titre d'exemple, le signal ctrl est un signal de commande d'un demi pont ayant son point milieu relié à l'antenne 100 (figure 1). Plus particulièrement, le demi pont comprend, par exemple, deux transistors MOS en série entre un noeud d'application d'un potentiel d'alimentation et un noeud d'application d'un potentiel de référence, l'antenne 100, par exemple une association en série d'une inductance et d'une capacité, étant connectée entre le noeud de connexion des deux transistors MOS l'un à l'autre et le noeud d'application du potentiel de référence ou le point milieu d'un deuxième demi pont.

Le dispositif 3 comprend un circuit de commande 300 recevant un signal d'horloge clk. Le dispositif 3 est configuré pour générer le signal ctrl dans un premier état pendant un premier nombre n1 donné de cycles du signal clk, et dans un deuxième état pendant un nombre n2 de cycles du signal clk, puis de nouveau dans le premier état pour n1 cycles du signal clk etc. Ainsi, la période du signal ctrl est égale à (n1+n2)*Tclk, avec Tclk la période du signal clk.

Les valeurs n1 et n2 sont stockées dans des registres reg auxquels a accès le circuit 300.

A titre d'exemple, la fréquence F du signal ctrl est égale à 1/((n1+n2)*Tclk) quand le bit à transmettre t_bit est à la valeur '1'. Dit autrement, la fréquence f1 du signal ctrl est égale à 1/((n1+n2)*Tclk), et un bit t_bit à la valeur '1' est transmis en X cycles successifs du signal ctrl, donc du signal 12, à la fréquence f1. Pour transmettre un bit t_bit suivant à la valeur '0', il faut changer la fréquence F du signal ctrl pour qu'elle soit égale à la fréquence f2 pendant les X cycles suivants du signal ctrl.

Pour cela, on pourrait penser à modifier la période Tclk du signal clk, d'où il résulterait une modification de la fréquence du signal ctrl. Toutefois, ce changement d'horloge doit être mis en oeuvre de manière très rapide, de sorte qu'au moins avant la fin du premier cycle du signal ctrl correspondant à la transmission du bit t_bit à la valeur '0', la période Tclk du signal clk soit égale à 1/((n1+n2)*f2)).

Cette modification de la période Tclk serait mise en oeuvre par un processeur du dispositif 10 (figure 1), dès réception d'un signal indiquant que X cycles du signal ctrl se sont écoulés. Du fait que le dispositif 10 peut mettre en oeuvre d'autres fonctions que celles déjà décrites, par exemple des fonctions de communication en champ proche ("Near Field Communication") ou NFC, des fonctions de communication via un bus série universel ("Universal Serial Bus") de type C, ou USB-C, qui sont commandée par le processeur, cela imposerait des contraintes temporelles fortes sur le processeur, ce qui n'est pas souhaitable.

En outre, en pratique, le signal clk est obtenu en divisant par un nombre entier la fréquence d'un signal périodique de fréquence plus élevée, par exemple un signal périodique fourni par un oscillateur. Cette division entière permet par exemple que la période Tclk soit égale à 1/((n1+n2)*f1). L'obtention du signal clk par une division entière du signal périodique de manière que la période Tclk soit égale à 1/((n1+n2)*f2) pose problème. En effet, selon l'écart entre les fréquences f1 et f2, cela peut nécessiter que la fréquence du signal périodique soit supérieure à plusieurs GHz, ce qui n'est pas souhaitable.

A titre d'exemple, pour une fréquence f1 égale à 110 KHz, et une fréquence du signal clk égale à 50 MHz, pour changer la période du signal ctrl de 40 ns de manière que le signal ctrl soit à la fréquence f2, il faut pouvoir modifier la fréquence du signal clk d'environ 0,4 %. En utilisant uniquement des divisions entières d'un signal périodique de fréquence plus élevée que celle du signal clk, cela implique que la fréquence de ce signal doit être égale à au moins 227 fois la fréquence du signal clk, c'est-à-dire être égale à au moins 11,35 GHz.

On pourrait alors penser, lorsque la période Tclk du signal clk doit être égale à 1/((n1+n2)*f2), à générer le signal clk en divisant le signal périodique de fréquence plus élevée par un nombre décimal non entier. Toutefois, cela n'est pas souhaitable car la mise en oeuvre d'une telle division est très complexe à mettre en oeuvre.

Plutôt que de modifier la période du signal clk, on pourrait penser à modifier la fréquence du signal ctrl en modifiant les valeurs n1 et/ou n2 qui sont stockées dans les registres reg. Toutefois, là encore, cette reprogrammation des registres reg serait faite par le processeur du dispositif 10 (figure 1), ce qui imposerait des contraintes temporelles non souhaitables au processeur. En outre, dans le cas où le dispositif 300 serait configuré pour générer d'autres signaux à la même fréquence que le signal ctrl, mais avec des formes d'ondes différentes, le nombre de registres à reprogrammer augmenterait, ce qui augmenterait encore les contraintes temporelles imposées au processeur.

Les problèmes évoqués ci-dessus du dispositif 3 sont encore plus prononcés dans le cas où l'écart entre les fréquences f1 et f2 peut être choisi par le dispositif 14 (figure 1), comme cela est, par exemple, requis par les versions 1.2.x de la spécification Qi, pages 106 et 107.

L'inventeur propose un procédé comprenant l'exécution d'un jeu d'instructions successives. Comme on le verra plus en détail ci-après, ce procédé permet de générer le signal ctrl modulé en fréquence, et donc d'émettre le signal 12 modulé en fréquence. Dans ce procédé, chaque instruction du jeu d'instructions successives correspond à (ou indique ou représente) une commutation d'un signal, c'est-à-dire un signal et une commutation de ce signal, un délai, et une condition sélectionnée parmi une première condition, une deuxième condition et une troisième condition. Les instructions du jeu d'instructions sont exécutées les unes après les autres. Chaque instruction est exécutée de la manière suivante.

Si la condition correspondant à l'instruction exécutée est la première condition, cela signifie que, peu importe la valeur du bit t_bit transmis, la commutation du signal correspondant à l'instruction est effectuée après que le délai correspondant à l'instruction se soit écoulé, c'est-à-dire à l'expiration de ce délai, le délai ayant comme point de départ la dernière commutation d'un signal effectuée lors de l'exécution d'une instruction précédente.

Si la condition correspondant à l'instruction exécutée est la deuxième condition et qu'un drapeau est à l'état actif, la commutation du signal correspondant à l'instruction est effectuée de la même façon que quand la condition est la première condition.

Si la condition correspondant à l'instruction exécutée est la troisième condition et que le drapeau est à l'état inactif, la commutation du signal correspondant à l'instruction est effectuée de la même façon que quand la condition est la première condition.

Si la condition correspondant à l'instruction exécutée est la deuxième condition et que le drapeau est à l'état inactif, la commutation du signal correspondant à l'instruction n'est pas effectuée, ou, dit autrement, l'état du signal correspondant à cette commutation est maintenu.

Enfin, si la condition correspondant à l'instruction exécutée est la troisième condition et que le drapeau est à l'état actif, la commutation du signal correspondant à l'instruction n'est pas effectuée, ou, dit autrement, l'état du signal correspondant à cette commutation est maintenu.

En outre, le jeu d'instructions comprend une instruction représentative d'une première commutation, par exemple de l'état haut à l'état bas, du signal ctrl, d'un premier délai et de la deuxième condition, qui est immédiatement suivie d'une autre instruction représentative de la même première commutation du signal ctrl, d'un deuxième délai et de la troisième condition. Ainsi, selon la valeur du drapeau, la première commutation du signal ctrl intervient à l'expiration du premier ou du deuxième délai, ce qui permet de modifier la période du signal ctrl en fonction de l'état du drapeau.

De préférence, le jeu d'instruction comprend une autre instruction représentative d'une deuxième commutation du signal ctrl, opposée à la première commutation, la deuxième commutation étant par exemple une commutation de l'état haut à l'état bas. Ainsi, chaque exécution complète du jeu d'instructions correspond à la génération d'au moins un cycle du signal ctrl.

Selon un mode de réalisation, chaque exécution complète du jeu d'instructions correspond à un cycle ou période du signal ctrl.

Selon un mode de réalisation, plusieurs exécutions complètes du jeu d'instructions sont mises en oeuvre les unes à la suite des autres, ou, dit autrement, successivement.

Selon un mode de réalisation, le drapeau est à l'état actif quand le bit t_bit à transmettre est à une première valeur, par exemple la valeur '1', et à l'état inactif quand le bit t_bit à transmettre est à une deuxième valeur, par exemple la valeur '0'.

L'inventeur propose également un dispositif adapté à mettre en oeuvre ce procédé. Le dispositif comprend un circuit de traitement configuré pour exécuter les unes à la suite des autres les instructions du jeu d'instructions, et un circuit de stockage ou de mémorisation dans lequel est enregistré le jeu d'instruction.

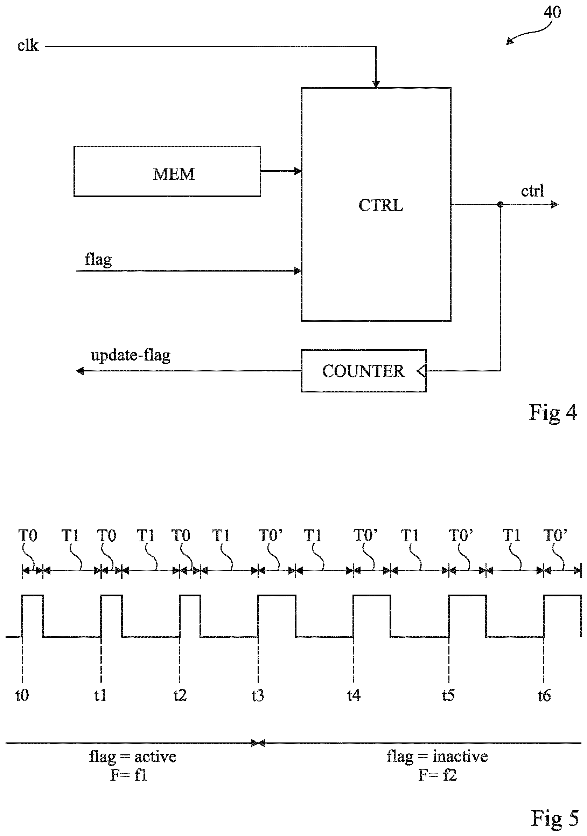

La figure 4 représente, de manière très schématique, et sous forme de blocs, un mode de réalisation d'un tel dispositif 40, ce dispositif 40 étant adapté à générer le signal ctrl modulé en fréquence en fonction de la valeur d'un bit t_bit à transmettre. Selon un mode de réalisation, ce dispositif 40 est mis en oeuvre dans le dispositif 10 de la figure 1, par exemple dans le circuit 102.

Le dispositif 40 comprend un circuit de commande CTRL configuré pour exécuter les instructions du jeu d'instructions les unes à la suite des autres. Le circuit CTRL est, comme le circuit 300 de la figure 3, cadencé par le signal d'horloge clk.

Selon un mode de réalisation, tous les délais correspondant aux instructions du jeu d'instructions correspondent chacun à un nombre de cycles ou périodes du signal clk. Ainsi, il suffit au circuit CTRL de compter le nombre de cycles du signal clk pour savoir quand un délai expire. A titre d'exemple, le circuit CTRL comprend un compteur configuré pour compter les cycles du signal clk, ce compteur étant par exemple réinitialisé après chaque exécution d'une instruction ayant conduit à une commutation d'un signal.

De préférence, la fréquence du signal clk est supérieure ou égale à 50 MHz, ce qui permet, par exemple, de générer le signal ctrl avec une fréquence f1 comprise entre 110 et 205 KHz, et que l'écart entre la période du signal ctrl à la fréquence f1 et la période du signal ctrl à la fréquence f2 puisse avoir des valeurs minimales de l'ordre de 40 ns, ce qui est notamment requis par les versions 1.2.x de la spécification Qi.

Le dispositif 40 comprend en outre un circuit de stockage, ou mémoire, MEM configuré pour stocker le jeu d'instructions. Le circuit CTRL a accès aux instructions stockées dans le circuit MEM.

Le circuit 300 reçoit le drapeau, référencé flag en figure 4.

En outre, selon un mode de réalisation, l'état du drapeau flag est mis à jour tous les X cycles du signal ctrl, par exemple tous les X=256 cycles. A cet effet, le dispositif 40 comprend, de préférence, un compteur COUNTER configuré pour compter X cycles du signal ctrl et pour indiquer, par exemple par un signal update_flag, lorsque X cycles ont été comptés et que le drapeau flag doit être mis à jour.

Selon un mode de réalisation, le dispositif 40 fait partie du dispositif 10 (figure 1) et la mise à jour du drapeau flag est effectuée par un processeur du dispositif 10 qui reçoit l'indication de mise à jour du drapeau flag, par exemple le signal update_flag, du compteur COUNTER.

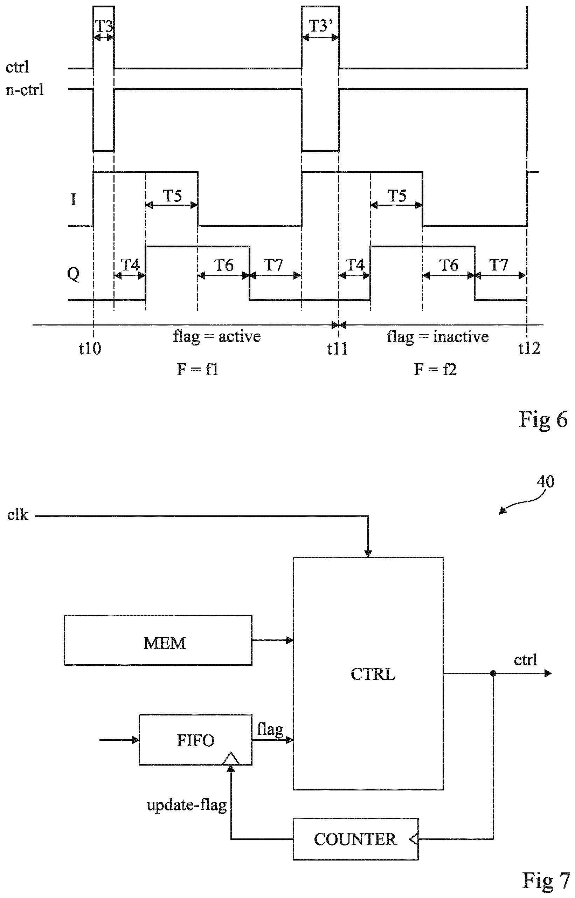

Des exemples de mises en oeuvre du procédé proposé ici, par exemple au moyen du dispositif 40, de préférence lorsque le dispositif 40 fait partie du dispositif 10 de la figure 1, vont maintenant être décrits en relation avec les figures 5 et 6.

La figure 5 illustre, sous la forme d'un chronogramme, un exemple d'un mode de mise en oeuvre du procédé proposé ici, par exemple au moyen du dispositif 40.

Dans l'exemple de la figure 5, le jeu d'instructions est constitué des instructions successives instr1, instr2 et instr3. Ces instructions sont par exemple enregistrées dans le circuit MEM du dispositif 40.

L'instruction instr1 correspond à une première commutation, dans cet exemple à l'état bas, du signal ctrl, à un délai T0 et à la deuxième condition selon laquelle le drapeau flag doit être actif pour que la première commutation du signal ctrl soit mise en oeuvre.

L'instruction instr2 correspond à la première commutation du signal ctrl, à un délai T0', dans cet exemple supérieur au délai T0, et à la troisième condition selon laquelle le drapeau flag doit être inactif pour que la première commutation soit mise en oeuvre.

L'instruction instr3 correspond à une deuxième commutation du signal ctrl, dans cet exemple à l'état haut, à un délai T1, et à la première condition selon laquelle la deuxième commutation doit être effectuée quelque soit l'état du drapeau flag.

A un instant t0, le drapeau flag est actif ("flag=active"), ce qui signifie, dans cet exemple, qu'un bit t_bit à la valeur '1' est en train d'être émis. En outre, l'instant t0 correspond à la fin d'une exécution complète du jeu d'instructions successives instr1, instr2 et instr3. La dernière commutation effectuée, à l'instant t0, est donc la commutation correspondant à l'instruction instr3, c'est-à-dire la commutation du signal ctrl à l'état haut dans cet exemple.

A partir de l'instant t0, l'instruction instr1 est exécutée, par exemple par le circuit CTRL du dispositif 40. Comme le drapeau flag est actif, à l'expiration du délai T0 de l'instruction instr1, c'est-à-dire à un instant t0+T0, la commutation correspondante du signal ctrl est effectuée, par exemple par le dispositif 40, et le signal ctrl est, dans cet exemple, commuté à l'état bas.

Une fois l'instruction instr1 exécutée, à l'instant t0+T0, l'instruction instr2 est exécutée, par exemple par le circuit CTRL. Comme le drapeau flag est à l'état actif, l'exécution de l'instruction instr2 n'entraîne aucune commutation du signal ctrl.

L'exécution du jeu d'instructions successives instr1, instr2 et instr3 se poursuit par l'exécution de l'instruction instr3. La commutation du signal ctrl correspondant à l'instruction instr3 doit être effectuée quelque soit l'état du drapeau flag, à l'expiration du délai T1 correspondant à l'instruction instr3. Le délai T1 ayant comme point de départ la commutation à l'état bas du signal ctrl, le signal ctrl est commuté, dans cet exemple à l'état haut, à un instant t1 égal à t0+T0+T1.

Entre les instants t0 et t1, l'exécution complète du jeu d'instructions successives instr1, instr2 et instr3 permet de générer un cycle du signal ctrl. Du fait que le drapeau flag est actif, la fréquence F est égale à f1, c'est-à-dire à 1/(T0+T1) dans cet exemple.

A l'instant t1, le nombre compté de cycles du signal ctrl est incrémenté d'une unité. Dans cet exemple, on considère qu'à l'instant t1, X-2 cycles du signal ctrl ont déjà été comptés. L'état du drapeau flag n'est donc pas mis à jour, ou, dit autrement, l'émission du bit t_bit courant n'est pas terminée.

L'exécution complète du jeu d'instructions est ensuite répétée, à partir de l'instant t1, et un nouveau cycle du signal ctrl est généré entre l'instant t1 et un instant t2 égal à t1+T0+T1. Comme le drapeau flag est actif, la fréquence F reste égale à f1.

A l'instant t2, le nombre compté de cycles du signal ctrl est incrémenté d'une unité et devient égal, dans cet exemple, à X-1. L'état du drapeau flag n'est donc pas mis à jour.

L'exécution complète du jeu d'instructions est ensuite répétée, à partir de l'instant t2, et un nouveau cycle du signal ctrl est généré entre l'instant t2 et un instant t3 égal à t2+T0+T1. Comme le drapeau flag est actif, la fréquence F reste égale à f1.

A l'instant t3, le nombre compté de cycles du signal ctrl est incrémenté et devient égal à X. L'état du drapeau flag est alors mis à jour, dans cet exemple à l'état inactif ("flag=inactive"). L'instant t3 correspond donc à la fin de l'émission d'un bit t_bit, dans cet exemple à la valeur '1', et au début de l'émission du bit t_bit suivant, dans cet exemple à la valeur '0'.

Ainsi, à partir de l'instant t3, l'instruction instr1 est exécutée. Comme le drapeau flag est à l'état inactif, l'exécution de l'instruction instr1 n'entraîne aucune commutation du signal ctrl.

L'exécution du jeu d'instructions se poursuit par l'exécution de l'instruction instr2. Comme le drapeau flag est inactif, à l'expiration du délai T0' de l'instruction instr2, c'est-à-dire à un instant t3+T0', la commutation correspondante du signal ctrl est effectuée et le signal ctrl est, dans cet exemple, commuté à l'état bas.

Une fois l'instruction instr2 exécutée, l'instruction instr3 est exécutée et le signal ctrl est commuté à l'état haut à un instant t4 égal à t3+T0'+T1.

Entre les instants t3 et t4, l'exécution complète du jeu d'instructions permet de générer un cycle du signal ctrl. Du fait que le drapeau flag est inactif, la fréquence F est égale à f2, c'est-à-dire à 1/(T0'+T1) dans cet exemple.

En outre, à l'instant t4, le nombre compté de cycles du signal ctrl est incrémenté d'une unité et devient égal à 1. En effet, à titre d'exemple, lorsque X cycles du signal ctrl ont été comptés, le compteur COUNTER du dispositif 40 est réinitialisé, soit de manière autonome soit sous le contrôle d'un autre circuit, par exemple par le processeur qui reçoit le signal update_flag.

L'exécution complète du jeu d'instructions est ensuite répétée, à partir de l'instant t4, et un nouveau cycle du signal ctrl est généré entre l'instant t4 et un instant t5 égal à t4+T0'+T1. Comme le drapeau flag est inactif, la fréquence F reste égale à f2.

L'exécution complète du jeu d'instructions est ensuite répétée, à partir de l'instant t5. Comme le drapeau flag est à l'état inactif, un nouveau cycle du signal ctrl est généré entre l'instant t5 et un instant t6 égal à t5+T0'+T1, la fréquence F restant égale à f2.

Dans l'exemple de la figure 5, la fréquence F du signal ctrl est égale à la fréquence f1=1/(T0+T1) jusqu'à l'instant t3, ce qui correspond à la transmission d'un bit t_bit à une première valeur, dans cet exemple la valeur '1', et, est égale à la fréquence f2=1/(T0'+1) à partir de l'instant t3, ce qui correspond à la transmission d'un bit t_bit à une deuxième valeur, dans cet exemple la valeur '0'.

On a décrit en relation avec la figure 5, un exemple dans lequel toutes les instructions du jeu d'instructions concernent des commutations d'un même signal, à savoir le signal ctrl. Dans d'autres exemples, les instructions du jeu d'instructions peuvent concerner des commutations de plusieurs signaux distincts. En particulier, une instruction peut concerner plusieurs signaux et les commutations de ces signaux. Cela permet de générer, par exemple au moyen du dispositif 40, plusieurs signaux distincts périodiques, de préférence à la même fréquence, comme cela va maintenant être illustré par la figure 6.

La figure 6 illustre, sous la forme de chronogrammes, un autre exemple d'un mode de mise en oeuvre du procédé proposé ici, par exemple au moyen du dispositif 40.

Dans l'exemple de la figure 6, le jeu d'instructions est constitué des instructions successives instr4, instr5 et instr6, instr7, instr8 et instr9. Les instructions sont par exemple enregistrées dans le circuit MEM du dispositif 40. Ce jeu d'instructions permet de générer simultanément 4 signaux ctrl, n_ctrl, I et Q. Les signaux I et Q sont, par exemple, utilisés pour démoduler le signal 12 modulé en amplitude vu par le dispositif 10 au niveau de l'antenne 100 (figure 1).

L'instruction instr4 correspond à une commutation à l'état bas du signal ctrl, à une commutation à l'état haut du signal n_ctrl, à un délai T3 et à la deuxième condition.

L'instruction instr5 correspond à une commutation à l'état bas du signal ctrl, à une commutation à l'état haut du signal n_ctrl, à un délai T3' et à la deuxième condition.

L'instruction instr6 correspond à une commutation à l'état haut du signal Q, à un délai T4 et à la première condition.

L'instruction instr7 correspond à une commutation à l'état bas du signal I, à un délai T5 et à la première condition.

L'instruction instr8 correspond à une commutation à l'état bas du signal Q, à un délai T6 et à la première condition.

L'instruction instr9 correspond à une commutation à l'état haut du signal ctrl, à une commutation à l'état bas du signal n_ctrl, à une commutation à l'état haut du signal I, à un délai T7 et à la première condition.

On considère, à titre d'exemple, que l'exécution du jeu d'instructions commence à un instant t10 où les signaux ctrl, n_ctrl, I et Q sont respectivement à l'état haut, à l'état bas, à l'état haut et à l'état bas. En outre, dans cet exemple, à l'instant t10 le drapeau flag est actif ("flag=active") pour transmettre un bit t_bit à une première valeur, par exemple la valeur '1'. On considère aussi, à titre d'exemple, que l'instant t10 correspond au début du dernier des X cycles du signal ctrl correspondant à la transmission de ce bit t_bit.

A partir de l'instant t10, comme le drapeau flag est actif, l'exécution de l'instruction instr4 conduit à une commutation du signal ctrl à l'état bas à un instant égal à t10+T3, et, simultanément, à une commutation à l'état haut du signal n_ctrl.

Comme le drapeau flag est actif, l'exécution de l'instruction suivante instr5 ne conduit à aucune commutation.

L'exécution de l'instruction suivante instr6 conduit à une commutation à l'état haut du signal Q, à un instant égal à t10+T3+T4.

L'exécution de l'instruction suivante instr7 conduit à une commutation à l'état bas du signal I, à un instant égal à t10+T3+T4+T5.

L'exécution de l'instruction suivante instr8 conduit à une commutation à l'état bas du signal Q, à un instant égal à t10+T3+T4+T5+T6.

Enfin l'exécution de l'instruction suivante instr9 conduit, simultanément, à une commutation à l'état haut du signal ctrl, à une commutation à l'état bas du signal n_ctrl et à une commutation à l'état haut du signal I, à un instant t11 égal à t10+T3+T4+T5+T6+T7.

Entre les instants t10 et t11, l'exécution complète du jeu d'instructions permet de générer un cycle du signal ctrl, et, simultanément, un cycle du signal n_ctrl, un cycle du signal I et un cycle du signal Q. Comme le drapeau flag est actif, la fréquence F du signal ctrl est égal à f1, la fréquence f1 étant égale à 1/(T3+T4+T5+T6+T7) dans cet exemple.

A l'instant t11, le nombre compté de cycles du signal ctrl est incrémenté et devient égal à X. Le drapeau flag est alors mis à jour, dans cet exemple à l'état inactif ("flag=inactive").

A partir de l'instant t11, une nouvelle exécution complète du jeu d'instructions débute.

Comme le drapeau flag est inactif, l'exécution de l'instruction inst4 ne conduit à aucune commutation.

L'exécution se poursuit avec l'exécution de l'instruction suivante instr5. Comme le drapeau flag est actif, l'exécution de l'instruction instr5 conduit, à un instant égal à t11+T3', simultanément à une commutation à l'état bas du signal ctrl et à une commutation à l'état haut du signal n_ctrl.

L'exécution des instructions successives instr6, instr7, instr8 et instr9 conduit successivement à une commutation à l'état haut du signal Q à un instant égal à t11+T3'+T4, à une commutation à l'état bas du signal I à un instant égal à t11+T3'+T4+T5, à une commutation à l'état bas du signal Q à un instant égal à t11+T3'+T4+T5+T6, et, simultanément, à une commutation à l'état haut du signal ctrl, à une commutation à l'état bas du signal n_ctrl et à une commutation à l'état haut du signal I à un instant t12 égal à t11+T3'+T4+T5+T6+T7.

Entre les instants t11 et t12, l'exécution complète du jeu d'instructions permet de générer un cycle du signal ctrl, et, simultanément, un cycle du signal n_ctrl, un cycle du signal I et un cycle du signal Q. Comme le drapeau flag est inactif, la fréquence F du signal ctrl est égal à f2, la fréquence f2 étant égale à 1/(T3'+T4+T5+T6+T7) dans cet exemple.

On notera qu'à l'instant t11, le nombre compté de cycles du signal ctrl est incrémenté mais reste inférieur au nombre X. Le drapeau flag n'est donc pas mis à jour.

La figure 7 représente, de manière schématique, et sous la forme de blocs, une variante de réalisation du dispositif 40 de la figure 4.

En figure 7, le dispositif 40 comprend en outre une file d'attente FIFO, par exemple une file d'attente du type premier entré, premier sorti ("first in - first out"), dans laquelle sont stockés des états successifs suivants du drapeau flag.

Le dispositif 40 est alors configuré pour mettre à jour l'état courant du drapeau flag avec l'état suivant du drapeau flag qui est stocké dans la file d'attente FIFO lorsque le nombre donné de cycles est atteint, le signal update_flag étant représentatif de cette indication.

Ainsi, dans ce mode de réalisation, plutôt que le processeur du dispositif 10 ne mette à jour l'état du drapeau flag à chaque fois que le compteur COUNTER indique, via le signal update_flag, que X cycles du signal ctrl ont été comptés, le processeur peut charger plusieurs états suivants successifs dans la file d'attente FIFO. De cette façon, lorsque le compteur COUNTER indique, via le signal update_flag, que X cycles du signal ctrl ont été comptés, l'état courant du drapeau est mis à jour avec l'état suivant stocké dans la file d'attente FIFO, sans interrompre le processeur.

Dans l'exemple de la figure 7, l'état courant du drapeau flag est disponible en sortie de la file d'attente FIFO, qui est reliée au circuit CTRL. En outre, la file d'attente FIFO est commandée, au moins en partie, par le signal update_flag, de manière que la file d'attente FIFO mette à jour sa sortie à chaque fois que le compteur COUNTER indique que X cycles du signal ctrl ont été comptés. A titre d'exemple, la file d'attente FIFO reçoit le signal update_flag.

Dans un autre exemple non représenté, le circuit 300 reçoit le signal update_flag et est configurée pour commander la mise à jour de la sortie de la file d'attente FIFO.

Dans les modes de réalisation et variantes décrits ci-dessus, de préférence, les instructions du jeu d'instructions sont configurées pour que chaque signal périodique généré par des exécutions complètes et successives du jeu d'instruction soit commuté exactement une fois à l'état bas et exactement une fois à l'état haut lors de chaque exécution complète du jeu d'instruction.

Par ailleurs, dans les modes de réalisation et variantes décrits ci-dessus, de préférence, l'écart ou différence ΔT entre les deux délais correspondant aux deux instructions qui visent chacune la même commutation du même signal, mais qui indiquent respectivement la deuxième condition et la troisième condition, est programmable. Appliqué à l'exemple de la figure 5, cela signifie que l'écart ΔT entre les délais T0 et T0' est programmable, et, appliqué à l'exemple de la figure 6, cela signifie que l'écart ΔT entre les délais T3 et T3' est programmable. Dit autrement, dans l'exemple de la figure 5, les délais T0 et T0' sont programmables, et, dans l'exemple de la figure 6, les délais T3 et T3' sont programmables.

De ce façon l'écart entre les fréquences f1 et f2 peut être reprogrammé en ne reprogrammant que cet écart ΔT ou l'instruction concernée, et non pas tout le jeu d'instruction. De préférence, cet écart ΔT correspond à un nombre entier de cycles d'horloge.

La prévision d'un écart ΔT programmable est, par exemple, intéressante lorsque l'une des versions 1.2.x de la spécification Qi est mise en oeuvre car l'écart entre les fréquences f1 et f2 est sélectionné par le dispositif, par exemple le dispositif 14 de la figure 1, qui reçoit le signal 12 modulé en fréquence.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la personne du métier est en mesure de prévoir d'autres jeux d'instructions successives que ceux présentés à titre d'exemple en relation avec les figures 5 et 6. En outre, la présente description ne se limite pas au cas où X est égal à 256, ni au cas où les bits transmis t_bit résultent d'un encodage de bits de donnée d_bit selon un encodage biphasé différentiel de Manchester. En outre, la personne du métier est en mesure de modifier l'état du drapeau flag qui correspond à un bit t_bit transmis à la valeur '1' par rapport à ce qui a été décrit à titre d'exemple.

Enfin, la mise en oeuvre pratique des modes de réalisation et variantes décrits est à la portée de la personne du métier à partir des indications fonctionnelles données ci-dessus. En particulier, la mise en oeuvre du dispositif 40, notamment du circuit CTRL, est à la portée de la personne du métier à partir des indications fonctionnelles données ci-dessus. A titre d'exemple, le circuit CTRL comprend une machine d'états, par exemple une machine d'états comprenant une première partie responsable de l'exécution des instructions et une deuxième machine d'états responsable de la lecture des instructions. La première partie de la machine d'état est par exemple configurée pour mettre en oeuvre l'exécution d'une instruction courante fournie par la deuxième partie de la machine d'état, c'est-à-dire qu'elle attend que le délai de l'instruction soit écoulé avant de mettre en oeuvre la ou les commutations de l'instruction. La deuxième partie de la machine d'état est par exemple configurée pour chercher, à partir de l'instruction en cours d'exécution, la prochaine instruction conduisant effectivement à une commutation d'un signal, en ignorant celles qui ne conduiraient pas à une commutation d'un signal en raison de l'état courant du drapeau, et pour fournir cette prochaine instruction à la première partie de la machine d'état.

## Revendications

1. Procédé d'exécution d'un jeu d'instructions successives mis en oeuvre dans un dispositif électronique adapté à transmettre un signal radiofréquence modulé en fréquence, dans lequel :
chaque instruction correspond à une commutation d'un signal (ctrl, n_ctrl, I, Q), un délai (T0, T0', T1, T2, T3, T3', T4, T5, T6, T7), et une condition sélectionnée parmi une première, une deuxième et une troisième conditions ;
chaque exécution d'une instruction comprend :
- effectuer, à l'expiration dudit délai, ladite commutation dudit signal si la condition est la première condition, si la condition est la deuxième condition et qu'un drapeau (flag) est à un état actif, et si la condition est la troisième condition et que le drapeau (flag) est à un état inactif, et
- ne pas effectuer ladite commutation si la condition est la deuxième condition et que le drapeau (flag) est à l'état inactif, et si la condition est la troisième condition et que le drapeau (flag) est à l'état actif ; et
une première instruction est représentative d'une première commutation d'un premier signal (ctrl), d'un premier délai (T0 ; T3) et de la deuxième condition et est immédiatement suivie d'une deuxième instruction représentative de ladite première commutation dudit premier signal (ctrl), d'un deuxième délai (T0' ; T3') et de la troisième condition.

2. Dispositif (40) adapté à transmettre un signal radiofréquence modulé en fréquence et à mettre en oeuvre le procédé selon la revendication 1, le dispositif comprenant :
- un circuit de mémorisation (MEM) dans lequel est enregistré le jeu d'instruction ; et
- un circuit de traitement (CTRL) configuré pour exécuter les instructions les unes après les autres.

3. Procédé selon la revendication 1 ou dispositif selon la revendication 2, dans lequel plusieurs exécutions du jeu d'instructions sont mises en oeuvre les unes à la suite des autres.

4. Procédé selon la revendication 1 ou 3 ou dispositif selon la revendication 2 ou 3, dans lequel chaque exécution complète du jeu d'instructions correspond à un cycle du premier signal (ctrl), le premier signal étant périodique.

5. Procédé ou dispositif selon la revendication 4, dans lequel un état courant du drapeau (flag) est mis à jour chaque fois qu'un nombre donné de cycles du premier signal (ctrl) est atteint, ledit nombre donné étant de préférence égal à 256.

6. Procédé ou dispositif selon la revendication 5, dans lequel des états successifs suivants du drapeau (flag) sont stockés dans une file d'attente (FIFO).

7. Dispositif selon l'une quelconque des revendications 2 à 6, comprenant un compteur (COUNTER) configuré pour compter ledit nombre donné de cycles du premier signal et pour indiquer que ce nombre donné de cycles est atteint, le dispositif étant configuré pour mettre à jour le drapeau (flag) lorsque le nombre donné de cycles est atteint.

8. Procédé selon l'une quelconque des revendications 1, 3 et 6 ou dispositif selon l'une quelconque des revendications 2 à 7, dans lequel l'état actif du drapeau (flag) détermine une fréquence (f1) du premier signal (ctrl) et l'état inactif du drapeau (flag) détermine une autre fréquence (f2) du premier signal.

9. Procédé ou dispositif selon la revendication 8, dans lequel une différence entre ladite fréquence (f1) et ladite autre fréquence (f2) est égale à l'inverse d'une différence entre les premier (T0 ; T3) et deuxième (T0' ; T3') délais.

10. Procédé selon l'une quelconque des revendications 1, 3 à 6, 8 et 9, ou dispositif selon l'une quelconque des revendications 2 à 9, dans lequel une différence entre les premier (T0 ; T3) et deuxième (T0' ; T3') délais est programmable.

11. Procédé selon l'une quelconque des revendications 1, 3 à 6 et 8 à 10, ou dispositif selon l'une quelconque des revendications 2 à 10, dans lequel chaque délai est égal à un nombre entier correspondant de cycles d'un signal d'horloge (clk).

12. Procédé ou dispositif selon la revendication 11, dans lequel une fréquence du signal d'horloge est supérieure ou égale à 50 MHz.

13. Procédé selon l'une quelconque des revendications 1, 3 à 6 et 8 à 12, ou dispositif selon l'une quelconque des revendications 2 à 12, dans lequel la fréquence du premier signal (ctrl) est comprise entre 110 KHz et 205 KHz.

14. Procédé selon l'une quelconque des revendications 1, 3 à 6 et 8 à 13, ou dispositif selon l'une quelconque des revendications 2 à 13, dans lequel le premier signal (ctrl) est un signal de commande d'une antenne, par exemple d'un demi pont auquel est connectée l'antenne, et dans lequel l'état actif du drapeau correspond à un premier état binaire d'un bit à transmettre via l'antenne et l'état inactif du drapeau correspond à un deuxième état binaire du bit à transmettre via l'antenne.

15. Chargeur sans fil (10) comprenant le dispositif (40) selon l'une quelconque des revendications 2 à 14.

## Patentansprüche

1. Ein Verfahren zum Ausführen eines Satzes von sukzessiven Anweisungen, die in einer elektronischen Vorrichtung umgesetzt werden, die eingerichtet ist, ein frequenzmoduliertes Funkfrequenzsignal zu übertragen, wobei:
jede Anweisung dem Folgenden entspricht, einem Schalten eines Signals (crtl, n_ctrl, I, Q), einer Verzögerung (T0, T0', T1, T2, T3, T3', T4, T5, T6, T7), und einer Bedingung, die aus einer ersten, zweiten und dritten Bedingung ausgewählt ist;
jede Ausführung einer Anweisung Folgendes aufweist:
- Durchführen, wenn die Verzögerung abgelaufen ist, des Schaltens des Signals, wenn die Bedingung die erste Bedingung ist, wenn die Bedingung die zweite Bedingung ist und ein Flag (flag) in einem aktiven Zustand ist, und wenn die Bedingung die dritte Bedingung ist und das Flag (flag) in einem inaktiven Zustand ist, und
- nicht Durchführen des Schaltens wenn die Bedingung die zweite Bedingung ist und das Flag (flag) in dem inaktiven Zustand ist, und wenn die Bedingung die dritte Bedingung ist und das Flag (flag) in dem aktiven Zustand ist; und
wobei eine erste Anweisung repräsentativ ist für ein erstes Schalten eines ersten Signals (crtl), für eine erste Verzögerung (T0; T3), und für die zweite Bedingung und wobei auf die erste Anweisung unmittelbar eine zweite Anweisung folgt, die repräsentativ ist für das erste Schalten des ersten Signals (crtl), für eine zweite Verzögerung (T0'; T3`) und für die dritte Bedingung.

2. Eine Vorrichtung (40), die in der Lage ist ein moduliertes Funkfrequenzsignal zu übertragen und das Verfahren nach Anspruch 1 umzusetzen, wobei die Vorrichtung Folgendes aufweist:
- eine Speichereinheit (MEM) mit dem Satz von Anweisungen darin gespeichert; und
- eine Verarbeitungseinheit (CTRL), die eingerichtet ist, die Anweisungen eine nach der anderen auszuführen.

3. Das Verfahren nach Anspruch 1 oder die Vorrichtung nach Anspruch 2, wobei eine Vielzahl von Anweisungen des Satzes von Anweisungen eine nach der anderen umgesetzt wird.

4. Das Verfahren nach Anspruch 1 oder 3 oder die Vorrichtung nach Anspruch 2 oder 3, wobei jede vollständige Ausführung des Satzes von Anweisungen einem vollständigen Zyklus des ersten Signals (crtl) entspricht, wobei das erste Signal periodisch ist.

5. Das Verfahren oder die Vorrichtung nach Anspruch 4, wobei ein gegenwärtiger Zustand des Flag (flag) jedes Mal aktualisiert wird, wenn eine bestimmte Anzahl von Zyklen des ersten Signals (crtl) erreicht wird, wobei die bestimmte Anzahl vorzugsweise gleich 256 ist.

6. Das Verfahren oder die Vorrichtung nach Anspruch 5, wobei nächste sukzessive zustände des Flag (flag) in einer Schlange (FIFO) gespeichert werden.

7. Die Vorrichtung nach einem der Ansprüche 2 bis 6, die einen Zähler (COUNTER) aufweist, der eingerichtet ist die bestimmte Anzahl von Zyklen des ersten Signals zu zählen und anzuzeigen, dass die bestimmte Anzahl von Zyklen erreicht wurde, wobei die Vorrichtung eingerichtet ist, das Flag (flag) zu aktualisieren, wenn die bestimmte Anzahl von Zyklen erreicht wurde.

8. Das Verfahren nach einem der Ansprüche 1, 3 oder 6 oder die Vorrichtung nach einem der Ansprüche 2 bis 7, wobei der aktive Zustand des Flag (flag) eine Frequenz (f1) des ersten Signals (crtl) bestimmt und der inaktive Zustand des Flag (flag) eine andere Frequenz (f2) des ersten Signals bestimmt.

9. Das Verfahren oder die Vorrichtung nach Anspruch 8, wobei ein Unterschied zwischen der Frequenz (f1) und der anderen Frequenz (f2) gleich ist zu dem Inversen einer Differenz zwischen der ersten (T0; T3) und zweiten (T0'; T3`) Verzögerung.

10. Das Verfahren nach einem der Ansprüche 1, 3 bis 6, 8 und 9 oder die Vorrichtung nach einem der Ansprüche 2 bis 9, wobei eine Differenz zwischen der ersten (T0; T3) und zweiten (T0'; T3') Verzögerung programmierbar ist.

11. Das Verfahren nach einem der Ansprüche 1, 3 bis 6 und 8 bis 10 oder die Vorrichtung nach einem der Ansprüche 2 bis 10, wobei jede Verzögerung gleich ist zu einer entsprechenden ganzen Anzahl von Zyklen eines Zeitgeber-Signals (clk).

12. Das Verfahren oder die Vorrichtung nach Anspruch 11, wobei eine Frequenz des Zeitgeber-Signals größer oder gleich 50 MHz ist.

13. Das Verfahren nach einem der Ansprüche 1, 3 bis 6 und 8 bis 12 oder die Vorrichtung nach einem der Ansprüche 2 bis 12, wobei die Frequenz des ersten Signals (crtl) im Bereich von 110 kHz bis 205 kHz ist.

14. Das Verfahren nach einem der Ansprüche 1, 3 bis 6 und 8 bis 13 oder die Vorrichtung nach einem der Ansprüche 2 bis 13, wobei das erste Signal (crtl) ein Signal zum Steuern einer Antenne ist, beispielsweise einer Halb-Brücke mit der daran verbundenen Antenne, und wobei der aktive Zustand des Flag einem ersten binären Zustand entspricht, und zwar eines Bits, das über die Antenne zu übertragen ist, und der inaktive Zustand des Flag einem zweiten binären Zustand entspricht, und zwar des Bits, das über die Antenne zu übertragen ist.

15. Ein drahtloses Ladegerät (10), das die Vorrichtung (40) nach einem der Ansprüche 2 bis 14 aufweist.

## Claims

1. A method of executing a set of successive instructions implemented in an electronic device adapted to transmit a frequency modulated radiofrequency signal, wherein:
each instruction corresponds to a switching of a signal (ctrl, n_ctrl, I, Q), a delay (T0, T0', T1, T2, T3, T3', T4, T5, T6, T7), and a condition selected among a first, a second, and a third conditions;
each execution of an instruction comprises:
- performing, when said delay has expired, said switching of said signal if the condition is the first condition, if the condition is the second condition and a flag (flag) is in an active state, and if the condition is the third condition and the flag (flag) is in an inactive state, and
- not performing said switching if the condition is the second condition and the flag (flag) is in the inactive state, and if the condition is the third condition and the flag (flag) is in the active state; and
a first instruction is representative of a first switching of a first signal (ctrl), of a first delay (T0; T3), and of the second condition and is immediately followed by a second instruction representative of said first switching of said first signal (ctrl), of a second delay (T0'; T3'), and of the third condition.

2. A device (40) capable of transmitting a modulated radiofrequency signal and of implementing the method according to claim 1, the device comprising:
- a storage circuit (MEM) having the set of instructions recorded therein; and
- a processing circuit (CTRL) configured to execute the instructions one after the others.

3. The method according to claim 1 or the device according to claim 2, wherein a plurality of executions of the set of instructions are implemented one after the others.

4. The method according to claim 1 or 3 or the device according to claim 2 or 3, wherein each full execution of the set of instructions corresponds to a cycle of the first signal (ctrl), the first signal being periodic.

5. The method or the device according to claim 4, wherein a current state of the flag (flag) is updated each time a given number of cycles of the first signal (ctrl) is reached, said given number being preferably equal to 256.

6. The method or the device according to claim 5, wherein next successive states of the flag (flag) are stored in a queue (FIFO).

7. The device according to any of claims 2 to 6, comprising a counter (COUNTER) configured to count said given number of cycles of the first signal and to indicate that this given number of cycles has been reached, the device being configured to update the flag (flag) when the given number of cycles has been reached.

8. The method according to any of claims 1, 3 and 6 or the device according to any of claims 2 to 7, wherein the active state of the flag (flag) determines a frequency (f1) of the first signal (ctrl) and the inactive state of the flag (flag) determines another frequency (f2) of the first signal.

9. The method or the device according to claim 8, wherein a difference between said frequency (f1) and said other frequency (f2) is equal to the inverse of a difference between the first (T0; T3) and second (T0'; T3') delays.

10. The method according to any of claims 1, 3 to 6, 8 and 9, or the device according to any of claims 2 to 9, wherein a difference between the first (T0; T3) and second (T0'; T3') delays is programmable.

11. The method according to any of claims 1, 3 to 6 and 8 to 10, or the device according to any of claims 2 to 10, wherein each delay is equal to a corresponding whole number of cycles of a clock signal (clk).

12. The method or the device according to claim 11, wherein a frequency of the clock signal is greater than or equal to 50 MHz.

13. The method according to any of claims 1, 3 to 6 and 8 to 12, or the device according to any of claims 2 to 12, wherein the frequency of the first signal (ctrl) is in the range from 110 kHz to 205 kHz.

14. The method according to any of claims 1, 3 to 6 and 8 to 13 or the device according to any of claims 2 to 13, wherein the first signal (ctrl) is a signal for controlling an antenna, for example, of a half-bridge having the antenna connected thereto, and wherein the active state of the flag corresponds to a first binary state of a bit to be transmitted via the antenna and the inactive state of the flag corresponds to a second binary state of the bit to be transmitted via the antenna.

15. A wireless charger (10) comprising the device (40) according to any of claims 2 to 14.
